# EUROPÄISCHE PATENTSCHRIFT

(11) **EP 0 746 482 B1**
(45) Veröffentlichungstag und Bekanntmachung des Hinweises auf die Patenterteilung: **16.07.1997**
(21) Anmeldenummer: 95907553.2
(22) Anmeldetag: 02.02.1995
(51) Int. Cl.: B60R 21/00, G01P 1/00, H01H 35/14

(54) **SENSOREINHEIT ZUM STEUERN EINES INSASSENSCHUTZSYSTEMS EINES KRAFTFAHRZEUGS**
SENSOR UNIT FOR THE CONTROL OF A VEHICLE-OCCUPANT PROTECTION SYSTEM
UNITE DE DETECTION POUR PILOTER LE SYSTEME PERMETTANT DE PROTEGER LES OCCUPANTS D'UNE AUTOMOBILE

(30) Priorität: 28.02.1994 DE 4406499
(43) Veröffentlichungstag der Anmeldung: 11.12.1996
(73) Patentinhaber: SIEMENS AKTIENGESELLSCHAFT, 80333 München (DE)
(72) Erfinder: DIRMEYER, Josef, D-92439 Bodenwöhr (DE); PLANKL, Christian, D-93055 Burgweinting (DE); GRUBER, Robert, D-93057 Regensburg (DE); PROBST, Heinrich, D-93105 Tegernheim (DE)
(86) Internationale Anmeldenummer: DE9500138
(87) Internationale Veröffentlichungsnummer: WO9523080

(56) Entgegenhaltungen:
- EP-A- 0 566 758
- DE-A- 3 918 407
- FR-A- 2 550 145
- GB-A- 2 245 775
- PATENT ABSTRACTS OF JAPAN vol. 17, no. 457 (P-1597) 20. August 1993 & JP,A,05 107 263 (MITSUBISHI ELECTRIC CORP.) 27. April 1993
- PATENT ABSTRACTS OF JAPAN vol. 13, no. 127 (P-848) (3475) 29. März 1989 & JP,A,63 298 165 (AISIN SEIKI CO LTD) 5. Dezember 1988

## Beschreibung

Die Erfindung betrifft eine Sensoreinheit zum Steuern eines Insassenschutzsystems eines Kraftfahrzeugs gemäß Oberbegriff von Patentanspruch 1.

Bei dieser bekannten Sensoreinheit (EP 0 566 758 A1) ist ein Sensor auf einer Leiterplatte befestigt. Die Leiterplatte befindet sich in einem Gehäuse, das teilweise mit einer Dämpfungsmasse ausgefüllt ist. Die Dämpfungsmasse soll mechanische Erschütterungen, die nicht von einem Unfall herrühren, so dämpfen, daß der Sensor nicht unbeabsichtigt beschädigt wird.

Eine solche Sensoreinheit ist jedoch recht aufwendig zu herzustellen, da die Dämpfungsmasse zuerst aushärten muß, bevor die Sensoreinheit in das Kraftfahrzeug montiert werden kann.

Das Problem der Erfindung ist es, eine Sensoreinheit zu schaffen, die einfach herzustellen ist, wobei mechanische Erschütterungen infolge eines Unfalls gut zu dem Sensor übertragen werden und schädigende Erschütterungen, die nicht von einem Unfall herrühren, stark gedämpft werden.

Dieses Problem wird erfindungsgemäß durch die Merkmale des Patentanspruchs 1 gelöst. Dabei weist die Sensoreinheit einen den Sensor schützenden und dämpfenden Halter auf, der den Sensor in einem wohl definierten Winkel zu einer Leiterplatte hält. Der Halter ist auf der Leiterplatte durch Löten befestigt.

Mit dieser Sensoreinheit werden mechanische Erschütterungen infolge eines Unfalls gut bis zu dem Sensor übertragen, der diese mechanischen Signale erfaßt und zur Verarbeitung weiterleitet, wodurch das Insassenschutzsystem, wie Airbag- und Gurtstrammersystem gesteuert werden. Der Dämpfungshalter schützt den Sensor vor Zerstörung, beispielsweise während der Herstellung und Montage der Sensoreinheit. Durch die geometrische Ausbildung des Dämpfungshalters ist eine winkelgetreue Ausrichtung des Sensors zur Fahrtrichtung möglich. Somit werden mechanische Erschütterungen infolge eines Unfalls effektiver erfaßt. Durch das Löten des Dämpfungshalters auf der Leiterplatte wird kein zusätzlicher Montageschritt benötigt, da die sonstigen Bauelemente auf der Leiterplatte ohnehin gelötet werden müssen.

Vorteilhafte Ausgestaltungen der Erfindung sind in den Unteransprüchen gekennzeichnet. Dabei kann der Sensor auf eine Sensorleiterplatte gelötet sein. Die Sensorleiterplatte wird von dem Dämpfungshalter gehalten und über Metallstifte, die mit der Sensorleiterplatte verbunden sind an die Leiterplatte gelötet. Der Sensor kann auch direkt auf die Leiterplatte gelötet sein. Besonders vorteilhaft ist es, den Dämpfungshalter aus einem Kunststoff oder Verbundwerkstoff herzustellen. Seine Dämpfungseigenschaften werden durch seine konstruktive Ausgestaltung und durch geeignete Materialauswahl bestimmt. Der Dämpfungshalter kann insbesondere ein Haltergerüst aus einem Material ohne besondere Dämpfungseigenschaften und einen Haltereinsatz aus einem Material mit guten Dämpfungseigenschaften aufweisen.

Ausführungsbeispiele der Erfindung sind im folgenden unter Bezugnahme auf die schematischen Zeichnungen näher erläutert.
Es zeigen:
- Figur 1:: eine perspektivische Ansicht der Sensoreinheit,
- Figur 2:: eine Seitenansicht eines zweiten Ausführungsbeispiels einer Sensoreinheit (Ausschnitt),
- Figur 3:: einen Schnitt durch die Sensoreinheit entlang der Linie III-III in Figur 2 und
- Figur 4:: einen Schnitt durch die Sensoreinheit entlang der Linie IV-IV in Figur 3.

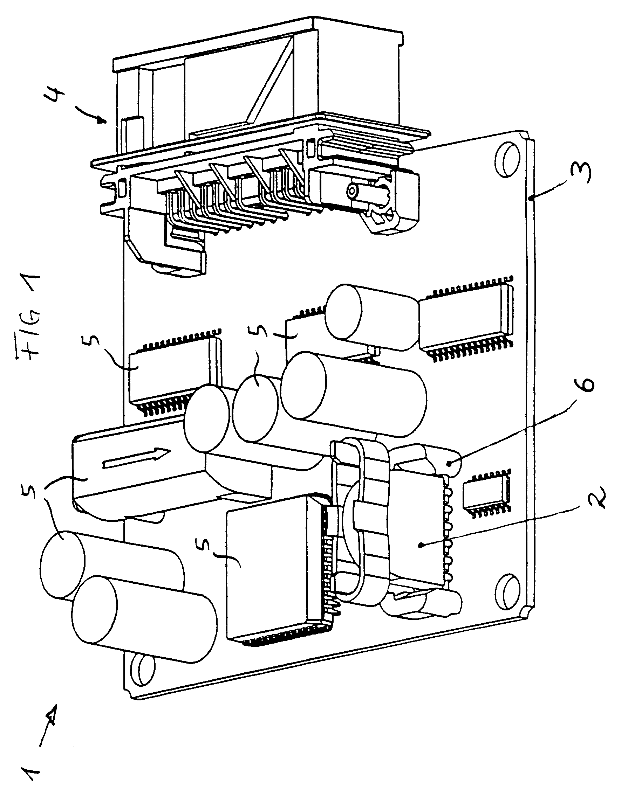

Eine erfindungsgemäße Sensoreinheit 1 (Figur 1) zum Steuern eines Insassenschutzsystems, wie beispielsweise zum Steuern der elektronischen Auslöseschaltung eines Airbag- und Gurtstrammersystems eines Kraftfahrzeugs, weist einen Sensor 2 auf, der Beschleunigungen und/oder Verzögerungen beispielsweise mittels einer seismischen Masse erfassen kann. Der Sensor 2 ist elektrisch mit einer eine Schaltung tragenden Leiterplatte 3 verbunden. In der Schaltung werden die Sensorsignale ausgewertet und über einen Steckverbinder 4 als Schnittstelle zu dem Airbag oder anderen Steuergeräten im Kraftfahrzeug weitergegeben. Die Schaltung ist schematisch durch diverse Bauelemente 5 auf der Leiterplatte 3 dargestellt.

Der Sensor 2 ist von einem Dämpfungshalter 6 eng umgeben, der ebenfalls auf die Leiterplatte 3 gelötet ist. Der Dämpfungshalter 6 stellt durch seine genügend große Haltekraft sicher, daß der Sensor 2 nicht durch mechanische Erschütterungen zerstört oder in seiner Einbaulage verändert werden kann. Der Dämpfungshalter 6 gewährleistet durch seine geometrische Ausgestaltung und seine Materialauswahl, daß er den Sensor 2 elastisch hält und mechanische Erschütterungen dämpft. Jedoch solche Erschütterungen, die infolge eines Unfalls den Sensor 2 erreichen sollen, gut zu dem Sensor 2 überträgt.

Der Dämpfungshalter 6 weist auf seiner Unterseite - in der Figur 1 nicht dargestellte - Metallstifte auf, mit denen der Dämpfungshalter 6 auf die Leiterplatte 3 gelötet ist. Bei der Montage wird der Dämpfungshalter 6 über den Sensor 2 und zusammen mit den Anschlußpins des Sensors 2 in entsprechende Bohrungen der Leiterplatte 3 gesteckt. Danach kann die Leiterplatte 3 mit allen bestückten Bauelementen - somit auch der Sensor 2 und der Dämpfungshalter 6 - in einem Arbeitsgang gelötet werden.

Durch den Dämpfungshalter 6 wird gewährleistet, daß der Sensor 2 in einer definierten Winkellage zur Leiterplatte 3 angeordnet ist. So kann beispielsweise der Sensor 2 in einem Winkel von etwa 90° zur Leiterplatte 3 angeordnet sein. Nach Einbau der Sensoreinheit 1 in ein nicht dargestelltes Gehäuse und Montage im Kraftfahrzeug, kann dann sichergestellt werden, daß sich der Sensor 2 in einer Ebene senkrecht zur Fahrtrichtung befindet. Somit werden die den Airbag auslösenden mechanischen oder akustischen Signale bei einem Unfall gut durch den Sensor 2 detektiert. Durch die geometrische Ausgestaltung des Dämpfungshalters 6 können aber auch beliebig andere wohl definierte Einbaulagen erzielt werden.

Durch den Dämpfungshalter 6 wird erreicht, daß der Sensor 2 während der Fertigung und der Montage nicht unbeabsichtigt zerstört oder beschädigt wird. Diese Bedingung wird erfüllt, wenn der Dämpfungshalter 6 so ausgestaltet ist, daß die Sensoreinheit 1 bei einem Test vor dem Einbau ins Kraftfahrzeug einen Fall aus 1,20 m Höhe auf einen Betonboden unbeschädigt übersteht. Die bei einem solchen Fall auftretenden mechanischen Erschütterungen werden durch den Dämpfungshalter 6 so gedämpft, daß der Sensor 2 nicht beschädigt oder in seiner Lage verschoben wird. Diese relativ harte Erschütterung unterscheidet sich jedoch von der relativ weichen Erschütterung infolge eines Unfalls. Diese weichen Erschütterungen muß der Sensor erfassen und an die Auswerteschaltung weiterleiten.

Der Dämpfungshalter 6 kann aus Kunststoff, wie beispielsweise Polyamid oder Polybutylenterephtalat, oder einem sonstigen Verbundwerkstoff bestehen. Der Dämpfungshalter 6 kann aber ebenso aus Metall hergestellt sein. Die geeignete Material-auswahl und die Geometrie des Dämpfungshalters wird durch Falltests ermittelt.

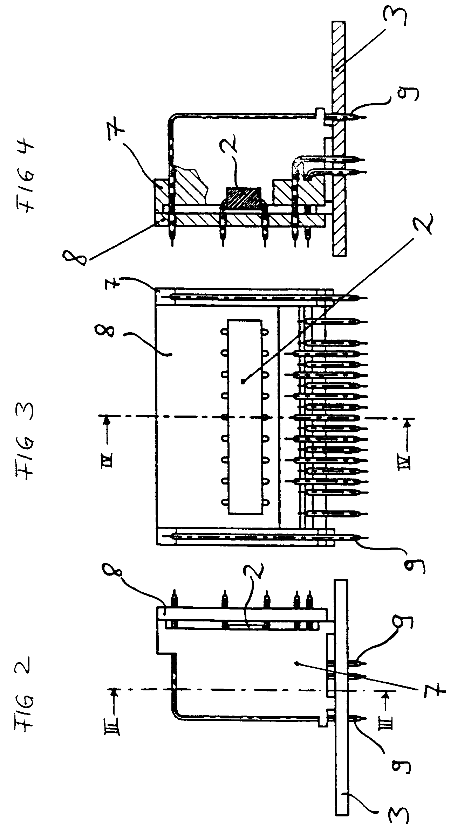

Eine zweite, erfindungsgemäße Ausführungsform der Sensoreinheit 1 ist in den Figuren 2 bis 4 dargestellt. Elemente gleicher Konstruktion oder Funktion tragen dabei dieselben Bezugszeichen wie in der Figur 1.

Der Sensor 2 ist in einem Dual-Inline-Gehäuse oder auch Chip-Gehäuse integriert. Damit der Sensor 2 in seiner Lage senkrecht zur Fahrtrichtung montiert werden kann, ist er auf eine Sensorleiterplatte 8 gelötet. Die Sensorleiterplatte 8 wird von einem Dämpfungshalter 7 umfaßt und somit wird der Sensor 2 gedämpft gehalten. Der Dämpfungshalter 7 ist bei diesem Ausführungsbeispiel wie ein Gehäuse ausgebildet, das den Sensor 2 umschließt und die Sensorleiterplatte 8 gedämpft hält.

Der Dämpfungshalter 7 weist gebogene Metallstifte 9 auf, die durch den Dämpfungshalter 7 nach außen ragen und sowohl mit der Sensorleiterplatte 8 als auch mit der Leiterplatte 3 elektrisch verbunden sind. Durch Löten der Metallstifte 9 auf der Leiterplatte 3 wird der Sensor 2 in seiner Lage arretiert und eine elektrische Verbindung des Sensors 2 zu der Leiterplatte 3 und damit zu der Schaltung hergestellt.

Durch den Dämpfungshalter 7 werden schädliche mechanische Erschütterungen gedämpft, jedoch mechanische Erschütterungen infolge eines Unfalls gut zum Sensor 2 übertragen.

Die Metallstifte 9 können nachträglich in den Dämpfungshalter 7 eingeschlossen werden oder bei der Fertigung des Dämpfungshalters 7 zugeführt werden. Vorteilhaft ist es, den Dämpfungshalter 7 (oder auch 6) als Spritzgußteil herzustellen, bei dem die Metallstifte 9 umspritzt sind.

Auch bei dem zweiten Ausführungsbeispiel wird der Dämpfungshalter 7 beispielsweise durch Schwallöten mit der Leiterplatte 3 verbunden. Bei der Montage des Sensors 2 wird der Dämpfungshalter 6, 7 zusammen mit der Sensorleiterplatte 8 auf die Leiterplatte 3 gesteckt. Der Dämpfungshalter 6, 7 ist so ausgebildet, daß keine zusätzliche, vorläufige Befestigung des Sensors 2 nötig ist, bevor der Sensor 2 mit dem Dämpfungshalter 7 auf die Leiterplatte 3 gelötet wird.

Durch die Geometrie des Dämpfungshalters 6, 7 und der Metallstifte 9 ist die Einbaulage des Sensors 2 in Bezug auf die Leiterplatte 3 definiert. Durch Löten des Dämpfungshalters 6, 7 auf die Leiterplatte 3 werden keine zusätzlichen Befestigungselemente wie Schrauben oder Nieten benötigt.

Bei einem dritten Ausführungsbeispiel ist der Sensor 2 von einem Dämpfungshalter 6 eng umgeben (Figur 1). Der Dämpfungshalter 6 weist ein Haltergerüst und einen Haltereinsatz auf, die in Figur 1 nicht dargestellt sind. Das Haltergerüst ist aus einem Material ohne besondere Dämpfungseigenschaften, beispielsweise aus Grilon XE 3453. Der Haltereinsatz ist aus einem Material mit guten Dämpfungseigenschaften - mögliche Werkstoffe sind der Beschreibung des ersten Ausführungsbeispiels zu entnehmen. Haltergerüst und Haltereinsatz sind geometrisch so ausgestaltet und miteinander verbunden, daß der Sensor 2 zu allen Seiten - seine Unterseite ausgenommen - auf dem Haltereinsatz aufliegt. Das Haltergerüst weist auf seiner Unterseite in Figur 1 nicht dargestellte Metallstifte zur Befestigung des Dämpfungshalters 6 auf der Leiterplatte 3 auf.

Durch diese Ausgestaltung des Dämpfungshalters werden schädliche mechanische Erschütterungen insbesondere durch den Haltereinsatz gedämpft, mechanische Erschütterungen infolge eines Unfalls jedoch gut zum Sensor 2 übertragen. Der Materialverbrauch für den Haltereinsatz kann gering gehalten werden.

Verfahrensschritte zur Fixierung der Metallstifte am Haltergerüst sowie des Dämpfungshalters 6 und des Sensors 2 auf der Leiterplatte 3 sind den Beschreibungen der beiden vorhergehenden Ausführungsbeispiele zu entnehmen.

## Patentansprüche

1. Sensoreinheit zum Steuern eines Insassenschutzsystems eines Kraftfahrzeugs mit einer eine Schaltung tragenden Leiterplatte (3), auf der ein Sensor (2), der Beschleunigungen und/oder Verzögerungen erfassen kann, durch einen Halter in einem definierten Winkel zur Leiterplatte (3) auf der Leiterplatte (3) durch Löten befestigt ist, **gekennzeichnet dadurch,** daß der Halter ein Dämpfungshalter (6, 7) ist, der den Sensor (2) gegen mechanische Erschütterungen dämpfend und gegen mechanische Einwirkungen schützend hält.

2. Steuergerät nach Anspruch 1, **dadurch gekennzeichnet,** daß der Sensor (2) auf einer Sensorleiterplatte (8) befestigt ist, die von dem Dämpfungshalter (7) gehalten wird, wobei starre Metallstifte (9), die mit der Sensorleiterplatte (8) verbunden sind, durch die Wand des Dämpfungshalters (7) führen und an der Leiterplatte (3) angelötet sind, wodurch eine elektrische Verbindung zwischen den beiden Leiterplatten (3, 8) und eine mechanische Befestigung des Dämpfungshalters (7) auf der Leiterplatte (3) hergestellt wird.

3. Steuergerät nach Anspruch 1, **dadurch gekennzeichnet,** daß der Dämpfungshalter (6) den Sensor (2) umgreift und zusammen mit den elektrischen Anschlüssen des Sensors (2) auf die Leiterplatte (3) gelötet ist.

4. Steuergerät nach Anspruch 1, **dadurch gekennzeichnet,** daß der Dämpfungshalter (6, 7) aus Kunststoff hergestellt ist.

5. Steuergerät nach Anspruch 1, **dadurch gekennzeichnet,** daß der Dämpfungshalter (6, 7) aus Metall hergestellt ist.

6. Steuergerät nach Anspruch 1 oder Anspruch 3, **dadurch gekennzeichnet,** daß der Dämpfungshalter (6) ein Haltergerüst und einen Haltereinsatz hat.

## Claims

1. Sensor unit for controlling an occupant protection system of a motor vehicle, having a printed circuit board (3) which bears a circuit and on which a sensor (2), which can detect accelerations and/or decelerations, is held at a defined angle to the printed circuit board (3) by a holder which is attached to the printed circuit board (3) by soldering, characterized in that the holder is a damping holder (6, 7) which holds the sensor (2) in a fashion damped against mechanical vibrations and protecting against mechanical effects.

2. Control device according to Claim 1, characterized in that the sensor (2) is attached to a sensor printed circuit board (8) which is held by the damping holder (7), rigid metal pins (9), which are connected to the sensor printed circuit board (8), leading through the wall of the damping holder (7) and being soldered to the printed circuit board (3), as a result of which an electrical connection is produced between the two printed circuit boards (3, 8) and a mechanical attachment of the damping holder (7) to the printed circuit board (3) is produced.

3. Control device according to Claim 1, characterized in that the damping holder (6) embraces the sensor (2) and is soldered onto the printed circuit board (3) together with the electrical connections of the sensor (2).

4. Control device according to Claim 1, characterized in that the damping holder (6, 7) is produced from plastic.

5. Control device according to Claim 1, characterized in that the damping holder (6, 7) is produced from metal.

6. Control device according to Claim 1 or Claim 3, characterized in that the damping holder (6) has a holder frame and a holder insert.

## Revendications

1. Bloc détecteur destiné à commander un système de protection d'occupants d'un véhicule à moteur comportant une plaquette de circuit imprimé (3) portant un circuit, sur laquelle un détecteur (2), qui peut détecter des accélérations et/ou des décélérations, est fixé par soudure par l'intermédiaire d'un support en faisant un angle défini avec elle (3),
caractérisé en ce que le support est un support d'amortissement (6, 7) qui maintient le détecteur (2) en amortissant les chocs mécaniques et en le protégeant contre les influences mécaniques.

2. Appareil de commande selon la revendication 1, caractérisé en ce que le détecteur (2) est fixé sur une plaquette de circuit imprimé de détecteur (8), qui est maintenue par le support d'amortissement (7), des broches métalliques (9) fixes, qui sont reliées à la plaquette de circuit imprimé de détecteur (8), traversant la paroi du support d'amortissement (7) et étant soudées à la plaquette de circuit imprimé (3), ce qui réalise une liaison électrique entre les deux plaquettes de circuit imprimé (3, 8) et une fixation mécanique du support d'amortissement (7) sur la plaquette de circuit imprimé (3).

3. Appareil de commande selon la revendication 1, caractérisé en ce que le support d'amortissement (6) enveloppe le détecteur (2) et est soudé avec les raccordements électriques du détecteur (2) sur la plaquette de circuit imprimé (3).

4. Appareil de commande selon la revendication 1, caractérisé en ce que le support d'amortissement (6, 7) est réalisé en matière synthétique.

5. Appareil de commande selon la revendication 1, caractérisé en ce que le support d'amortissement (6, 7) est réalisé en métal.

6. Appareil de commande selon la revendication 1 ou la revendication 3, caractérisé en ce que le support d'amortissement (6) a un cadre de support et un insert de support.
